# EUROPEAN PATENT APPLICATION

(11) **EP 0 825 615 A2**
(43) Date of publication of application: **25.02.1998**
(21) Application number: 97830413.7
(22) Date of filing: 05.08.1997
(51) Int. Cl.: G11C 29/00

(54) **System and method for testing audio RAM memories**

(30) Priority: 05.08.1996 IT RM960563
(71) Applicant: TEXAS INSTRUMENTS INCORPORATED, Dallas, Texas 75243 (US); TEXAS INSTRUMENTS ITALIA S.p.A., 67051 Avezzano (AQ) (IT)
(72) Inventor: Savarese, Giuseppe, 80122 Napoli (IT); Di Zenzo, Maurizio, 00040 Roccapriora (RM) (IT)
(74) Representative: Taliercio, Antonio

(57) **Abstract**

A test system for SIMM memory modules assembled by use of failing memory chips, characterized in that, for ascertaining the failure rate and the related addresses, a circuitry is provided which comprises, for a reference write phase, a pattern register (10) having a 32 bit input from the data bus and a 48 bit output to a pattern inverter (11) also having a 48 bit output (Dₒᵤₜ) and, for a comparison write phase, a pattern inverter (13) having a 48 bit input (Dᵢₙ) connected to a data comparator (14) and, through said comparator, to an error coder, having a 32 bit output to the data bus.

## Description

This invention broadly relates to ARAM memories and, more particularly, it concerns a system for enabling use of such memories in applications wherein the standard specifications would require memories of better performances in respect of their failure rate.

Even more particularly, this invention relates to a system for checking or testing SIMM (Single In-line Memory Modules) memory modules obtained by means of ARAM (Audio grade RAM) memory chips and designed for use in computers and like.

DRAM Audio memories, also designated as ARAM memories, are dynamic DRAM memories having a certain failure rate, due to the fact that they have some failing bit locations in casual or random positions. ARAM memories are employed in audio applications, such as telephone transponders or answering machines, because their failure rate is such that a voice message stored therein can be retrieved without noticeable defects in view of the fact that the human ear is adapted to replenish any lacking information by means of integration and interpolation mechanisms.

Use of these memories in these applications, therefore, does not raise appreciable problems, unless certain failure rate limits are overcome. They could not be anyway utilized, for instance, when they have completely failing columns or rows: not even the human ear, in fact, could replenish such a relevant lack of information by means of its integration and interpolation mechanisms. The specifications of these memories, therefore, are not only aimed at establishing a maximum failure rate limit, but they also introduce a further restriction that the defects be located in random locations.

In addition to these restrictions, even if 99,9% of the memory locations were properly operating or error free, such ARAM memories could not be utilized in conventional computer applications, due to the fact that the addresses of the failing bits are randomly dispersed in the relevant memory array.

In other words, when a conventional ARAM memory is considered, it is conceivable that a suitable system be designed to correct any failing bits, by making recourse to a correction system assimilable to a transmissive channel: namely a channel in some manner affected by noise. The failing memory problem can be solved by assimilating the memory and consequently the memory scan to a bit string to be corrected by adopting the same procedures as for transmissive channels.

If, however, in transmissive channels, we are coping with a string that is substantially sequential, the string to be considered in computer applications is certainly random rather than sequential. As a result, it is necessary to study an error code adapted to be applied to information storable in or retrievable from the memory in random way.

As it has been described and claimed in a copending patent application in the name of the same applicant, filed at the same date hereof, this problem is solved by providing SIMM memory modules comprising ARAM memory chips with an internal address bus for each memory chip and an ASIC module for external world interface, adapted to correcting the following failure categories:
A - failures involving a single bit in a code word, which are corrected by application of a conventional error correction code (ECC),
B - failures involving multiple bits in a single code word, each bit coming from a different memory chip, which are corrected by conversion from a condition of *m* errors in a single code word to a condition of *m* code words, each containing one error,
C - failures involving multiple bits in a single code word existing in a single memory chip, which are corrected by utilizing an associative memory incorporated in said ASIC module in order to store/retrieve the addresses identified during the test stage as well as all general data generated during normal operation in respect of all failing locations.

It is a specific object of this invention to provide a specialized apparatus with which a suitable software program operates to check or test SIMM modules as above mentioned, wherein not-compliant memory chips are utilized, such chips being not corresponding or according to the standard specifications for the intended application. These chips are also designated in a different terminology as SS (Secondary Silicon) memory chips.

Any known equipment for checking or testing memory chips is specifically designed to check the conformity or compliance of such chips to the product specifications. They furnish an information assembly, such as the speed selection, the fail mode and like, in a simple format (go/no-go or acceptable/not-acceptable). They have been found, however, to be completely inefficient when they are requested to furnish and to handle fail rate data in respect of the memory cells.

Furthermore, it should be considered that the test procedures adopted in manufacturing memory chips are not perfectly adapted to handle failures of different categories and typologies and it is almost impossible to make significant improvements thereto.

In most circumstances, the above quoted not-compliant products are identified and classified based upon criteria or according to rather indefinite categories, thereby leaving the responsibility to use them in effective and inexpensive manner to the end users.

It is a specific object of this invention to define the minimum requirements in terms of equipment and test procedures for manufacturing SIMM modules based upon use of not-compliant memory chip, also designated as SS chips.

As it is also described in above mentioned copending patent application, it is possible to manufacture a SIMM module based upon use of a SS chip, in which an ASIC module is implemented for interfacing a memory array to a Host System through a standard connector, namely a connector with 72 pins or 32 data input/output (I/O) ports. It has been realized, however, that this connector is in effect a real bottle neck in the test system, which should cope with the need to access to each individual I/O port (namely 48) of the memory array.

Aiming at solving this problem, which is an object of this invention, the above mentioned ASIC module should be designed so as to include a specific circuitry, enabled during the test stage, to enroute into a data path having a 32 bit width a data stream of a larger width.

The objects of this invention are achieved by means of a test system for SIMM memory modules assembled by use of failing memory chips, wherein, for ascertaining the failure rate and the related addresses, a circuitry is provided which comprises, for a reference write phase, a pattern register having a 32 bit input from the data bus and a 48 bit output to a pattern inverter also having a 48 bit output (Dₒᵤₜ) or, for a comparison write phase, a pattern inverter having a 48 bit input (Dᵢₙ) connected to a data comparator and, through said comparator, to an error coder, having a 32 bit output to the data bus.

In the preferred embodiment, a topologic inverter is provided between said pattern inverters for the write and read phases, in order to complement the data flow and to write true data into the memory locations.

Furthermore, in a preferred embodiment, said SIMM module substantially comprising a memory array, said ASIC module, as well as a Fail Memory Register is interfaced, during the test procedure, by means of an interface circuitry to a FIFO (First-In-First-Out) memory, in which the address of the failing word and the coded error information are stored.

Further details and advantages of this invention will be evident from the following specification by referring to the enclosed drawings wherein the preferred embodiment is shown by way ot illustration and not by way of limitation.

In the drawings:
Figure 1 shows a block diagram of the circuitry included in the ASIC module according to this invention,
Figure 2 shows a block diagram of the scope function to be implemented in order to locate the real positions of the failing bits,
Figure 3 shows a circuitry for storing the address of the failing word and the coded error information in a FIFO memory,
Figure 4 shows a flow chart adapted to handle various types of memory organizations, accesses, ECC codes, failure rates for the same SIMM module.

By referring now to the drawings, in the first place, it should be considered that a check or test equipment for memories writes a certain reference data pattern into the device under test (DUT) and thereafter it retrieves such data and compares the retrieved data to the reference pattern initially entered during the write phase. The test is considered as positive when a coincidence or match condition is found, but any difference therebetween is considered as a fail or error condition (failing or error bit).

When a SS memory chip is tested, the starting consideration to be made relates to the fact that the involved chips are non-compliant chips, namely chips having not sufficient performances with respect to the application which the chips are intended for, this means that the object of the test is not to establish whether the chips are in agreement with the specifications or not, but rather to ascertain the amount or grade of their performance differences and the related addresses.

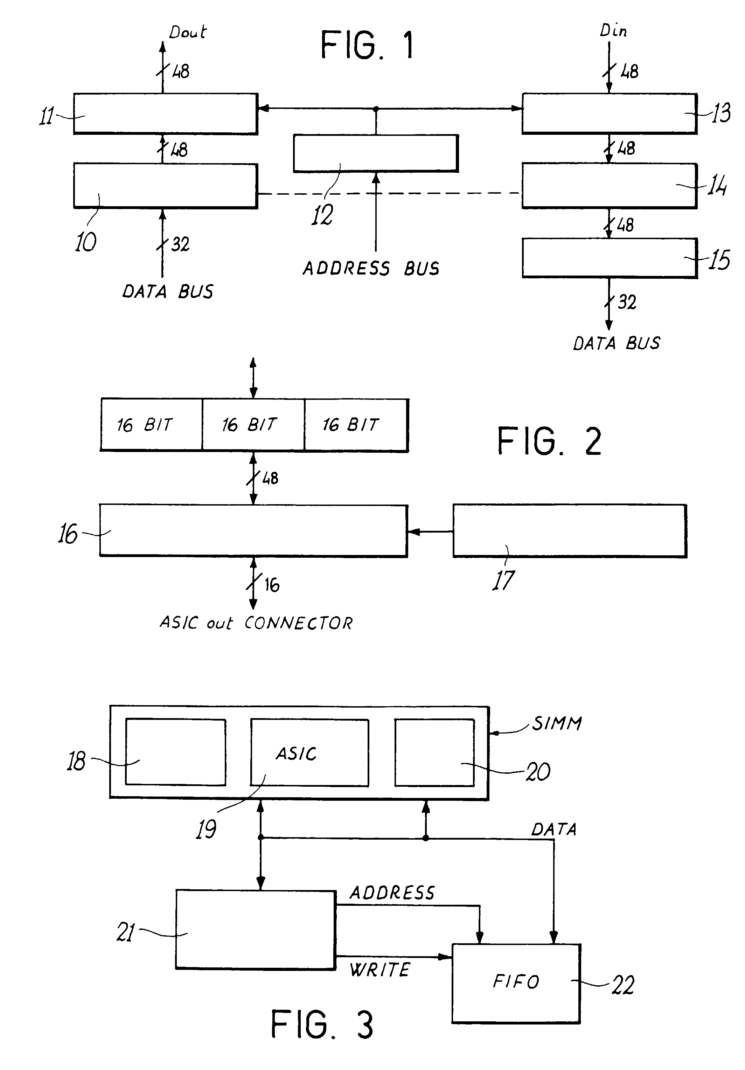

This function is carried out by the circuitry of Figure 1, where it can be observed that, as far as the reference write phase is concerned, a pattern register 10 is provided, said pattern register having a 32 bit input from the data bus and a 48 bit output to a pattern (write) inverter 11, also having a 48 bit output Dₒᵤₜ. As far as the retrieving phase is concerned, a pattern (read) inverter 13 is provided, such pattern inverter having a 48 bit input Dᵢₙ, connected to a data comparator 14 and, through this comparator, to an error coder 15 having a 32 bit output to the data bus.

Before starting the test procedure, the pattern register 10 is loaded with the selected bit pattern and, during the test procedure, the data are transferred to the interested memory chips. Said bits are transferred from this register, rather than from the data bus, which has a 32 bit capability. The topologic inverter block 12 is provided for complementing the data stream, in order to write "true data" into the memory locations, which is carried out by introducing a specific polarity into the concerned memory cell.

In a read mode, the data retrieved from the memory chips is compared to the data contained in the pattern register 10 by means of comparator 14. The output of data comparator 14 is coupled to an error coder 15 which will furnish the result of the comparison, in compact format, to the test apparatus or to a suitable dedicated CPU unit. The error coder couples its 32 bit output to the data bus.

The implemented approach provided for grouping the data input I/O ports into a four bit assembly and the coder will furnish for each assembly the following indications:
- no error took place,
- one error took place,
- multiple errors took place.

When this technique is applied, the information relating to 48 bits (twelve groups of four bits) can be concentrated into 24 bits, so that it can freely flow along a data path having a capability of 32 bits.

Aiming at ascertaining the real positions of the error or failing bits, it is necessary to implement a scanning or "scope" function, as it has been shown in the block diagram of Figure 2.

As it can be observed, such a function should be adapted to transfer selected bit groups, in this case three groups of 16 bits, to the 16 bit connector of the SIMM module, in pre-established locations, such as for instance, D0-D15, by means of a multiplexer block 16 and of a scope function register block 17. This function can be useful for an off-line engineering analysis.

During execution of the test procedure, the concerned SIMM module substantially comprising the memory matrix or array 18, the ASIC module 19 as well as the Fail Memory Register 20, will be interfaced by means of a specialized interface circuitry 21 to a FIFO (First-In-First-Out) memory 22, where the failing word address and the coded error information are stored. This is illustrated in Figure 3.

Said FIFO memory 22 should have a sufficient width to store the above mentioned information and a sufficient depth to store the failure data connected with a whole row or with a whole column.

The data of the FIFO memory will be stored in a mass storage device for further processing.

By utilizing the failure data stored during the check or test procedure, it is possible to draft information tables to be permanently stored in a Failing Location Register (not shown) implemented in the SIMM module. This register can be realized on a separate chip or it can be integrated in the same ASIC module, according to the available technology.

Furthermore, multiple Error Correction Codes (ECC) can be implemented in said ASIC module, each error correction code being optimized in view of specific failure patterns or with different redundancy requirements, directly affecting the cost of the end product.

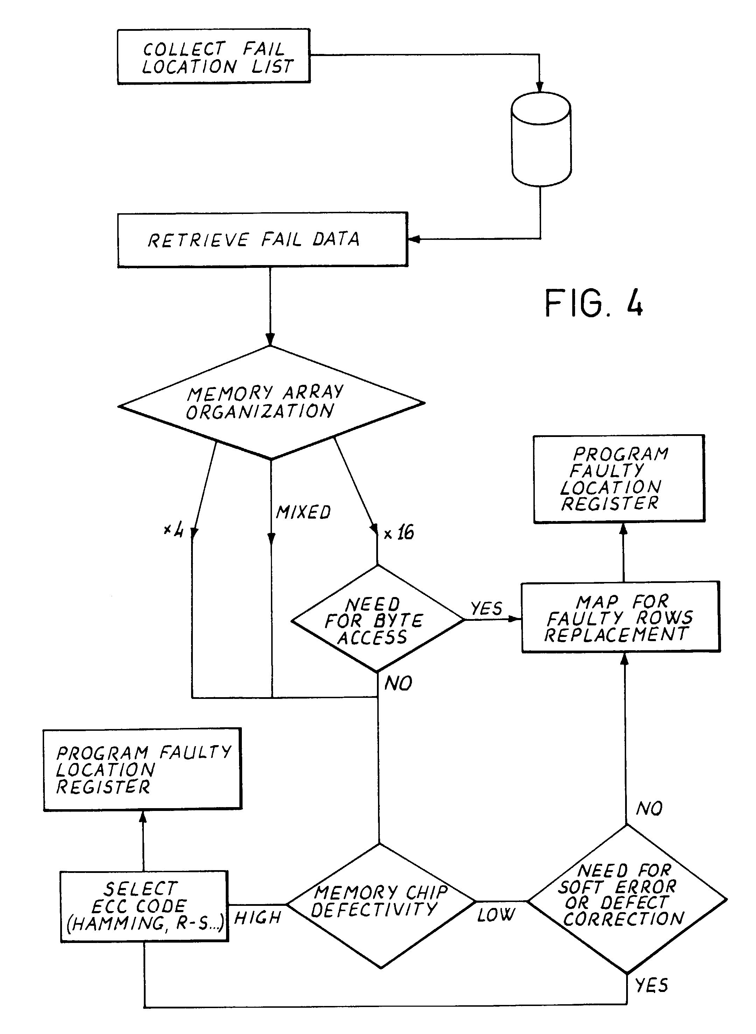

The flow chart as shown in Figure 4 illustrates the program flow adapted to handle, for the same SIMM module, various organization types of the memory array (for instance, by 4, mixed or by 16), various types of access to the memory array (by byte, by word, etc.), various failure rates (high or low) in the memory chips. The flow chart of Figure 4 does not need further explanations, as it will be easily understood by those skilled in the art.

The batch under test can be sorted into various product categories, according to the kind of the selected ECC code and of the failure rate found.

Of course, upon completing the programming operation of the failing location register and the classification of the DUT devices, a conventional go/no-go test procedure can be applied to the individual products, before forwarding them to the consumers.

The preferred embodiment of this invention has been hereinbefore explained, but it should be understood that those skilled in the art can made variations and changes therein without departing from the scope of this invention.

## Claims

1. A test system for SIMM memory modules assembled by use of failing memory chips, characterized in that, for ascertaining the failure rate and the related addresses, a circuitry is provided which comprises, for a reference write phase, a pattern register (10) having a 32 bit input from the data bus and a 48 bit output to a pattern inverter (11) also having a 48 bit output (Dₒᵤₜ) and, for a comparison write phase, a pattern inverter (13) having a 48 bit input (Dᵢₙ) connected to a data comparator (14) and, through said comparator, to an error coder, having a 32 bit output to the data bus.

2. A test system according to claim 1, characterized in that a topologic inverter (12) is provided between said pattern inverters (11, 13) for the write and read phases, in order to complement the data flow and to write true data into the memory locations.

3. A test system according to claims 1 and 2, characterized in that for ascertaining the real positions of the error or failing bits, a scope function is implemented, adapted to transfer selected bit groups to the connector of the SIMM module, in pre-established locations, by means of a multiplexer block (16) and of a scope function register block (17).

4. A test system according to any of claims 1 - 3, characterized in that said SIMM module substantially comprising a memory array (18), said ASIC module (19), as well as a Fail Memory Register (20), is interfaced, during the test procedure, by means of an interface circuitry (21) to a FIFO (First-In-First-Out) memory (22), in which the address of the failing word and the coded error information are stored.

5. A test system according to claim 4, characterized in that said FIFO memory (22) has a sufficient width to store said information and a sufficient depth to store the failure data connected with a whole row or with a whole column.

6. A test system according to claim 4 or to claim 5, characterized in that the data of said FIFO memory (22) is stored in a mass memory for further computation.

7. A test system according to any of the preceding claims, characterized in that a Failing Location Register is implemented in said SIMM module for permanently storing all fail data detected during the test stage, in order to draft a fail map.

8. A test system according to any of the preceding claims, characterized in that multiple Error Correction Codes (ECC) are implemented in said ASIC module, each error correction code being optimized in view of specific failure patterns or with different redundancy requirements.

9. A test method performed by means of a test system according to any of the preceding claims, characterized in that the program flow by which it is performed is adapted to handle, for the same SIMM module, various organization types of the memory array, various types of access to the memory array, various ECC code types, various failure rates in the memory chips.

10. A test system for SIMM memory modules assembled by use of failing memory chips according to any of the preceding claims.
